# EUROPÄISCHE PATENTSCHRIFT

(11) **EP 3 213 095 B1**
(45) Veröffentlichungstag und Bekanntmachung des Hinweises auf die Patenterteilung: **19.05.2021**
(21) Anmeldenummer: 15786959.5
(22) Anmeldetag: 28.10.2015
(51) Int. Cl.: G01R 31/52, H01H 9/00, G01R 31/62

(54) **TRANSFORMATORPRÜFVORRICHTUNG UND VERFAHREN ZUM PRÜFEN EINES TRANSFORMATORS**
TRANSFORMER TEST DEVICE AND METHOD FOR TESTING A TRANSFORMER
DISPOSITIF DE TEST DE TRANSFORMATEUR ET PROCÉDÉ DE TEST D'UN TRANSFORMATEUR

(30) Priorität: 30.10.2014 AT 507832014
(43) Veröffentlichungstag der Anmeldung: 06.09.2017
(73) Patentinhaber: Omicron electronics GmbH, 6833 Klaus (AT)
(72) Erfinder: KAUFMANN, Reinhard, A-6721 Thüringerberg (AT); UNTERER, Boris, A-6800 Feldkirch (AT); PÜTTER, Markus, A-6832 Sulz (AT)
(74) Vertreter: Banzer, Hans-Jörg
(86) Internationale Anmeldenummer: PCT/EP2015/075018
(87) Internationale Veröffentlichungsnummer: WO 2016/066701

(56) Entgegenhaltungen:
- EP-A1- 1 456 678
- US-A1- 2004 124 860
- US-A1- 2014 210 495
- US-A1- 2014 210 495
- US-B1- 6 809 525
- "Diagnostic Testing Solutions for Power Transformers", , 30. Mai 2013 (2013-05-30), Seiten 1-32, XP055196347, Gefunden im Internet: URL:https://www.omicron.at/fileadmin/user_ upload/pdf/literature/Transformer-brochure -ENU.pdf [gefunden am 2015-06-17]
- "CPC 100 Multi-functional primary test system for substation commissioning and maintenance", , 1. April 2012 (2012-04-01), Seiten 1-48, XP055243062, Gefunden im Internet: URL:https://www.omicronenergy.com/fileadmi n/user_upload/pdf/literature/CPC-100-Broch ure-ENU.pdf [gefunden am 2016-01-20]
- "Diagnostic Testing Solutions for Power Transformers", , 30 May 2013 (2013-05-30), pages 1-32, XP055196347, Retrieved from the Internet: URL:https://www.omicron.at/fileadmin/user_ upload/pdf/literature/Transformer-brochure -ENU.pdf [retrieved on 2015-06-17]

## Beschreibung

Die Erfindung betrifft eine Transformatorprüfvorrichtung nach Anspruch 1 und ein Verfahren zum Prüfen von Transformatoren nach Anspruch 8.

Die Erfindung betrifft insbesondere derartige Vorrichtungen und Verfahren, bei denen wenigstens während eines Teils einer Transformatorprüfung eine Wicklung des Transformators kurzgeschlossen wird.

### HINTERGRUND

In der Broschüre "Diagnostic Testing Solutions for Power Transformers" von OMICRON electronics GmbH, XP055196347, wird ein Instrument für eine Kurzschluss-Impedanzmessung bei Transformatoren offenbart.

Die Druckschrift US 2014/0210495 A1 beschreibt Lasttestmaschinen, welche eingesetzt werden, um elektrische Lasttests bei Stromversorgungen durchzuführen. Dabei werden Schaltmittel eingesetzt, um Verbindungskabel oder Kurzschlussbrücken mit Widerstandsgruppen zu verbinden. Ein Schaltabschnitt, welcher eine Schalteinrichtung und eine Steuerung aufweist, dient dazu, eine Verbindung zu einer Stromversorgung zu ändern. Weiterer relevanter Stand der Technik findet sich in den Dokumenten US6809525 und US 2004/124860.

Transformatoren werden als Bestandteile von Energieversorgungsnetzen verwendet. Transformatoren können zur Spannungswandlung von einem ersten Wert an einer Oberspannungsseite zu einem zweiten Wert, der kleiner als der erste Wert ist, an einer Unterspannungsseite eingesetzt werden.

Die Bestimmung von Eigenschaften eines Transformators durch eine Transformatorprüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Transformatorprüfungen beinhalten die Bestimmung eines statischen Widerstands, die Bestimmung eines dynamischen Widerstands, die Bestimmung eines Übersetzungsverhältnisses und/oder die Bestimmung einer Streuimpedanz oder Streuinduktivität. Bei einer statischen Widerstandsmessung kann ein Gleichstrom in eine Wicklung des Transformators eingespeist werden, und die Spannung kann gemessen werden. Bei einer dynamischen Widerstandsmessung kann das Übersetzungsverhältnis des Transformators mit einem Stufenschalter während der Messung umgeschaltet werden. Eine Spannung, ein Strom und/oder ein Widerstand können erfasst und ausgewertet werden. Aus dem Verlauf der gemessenen Parameter können beispielsweise Rückschlüsse auf einen Zustand des Stufenschalters gezogen werden.

Bei wenigstens einem Teil einer Transformatorprüfung kann eine Wicklung des Transformators, beispielsweise eine Wicklung auf der Unterspannungsseite, kurzgeschlossen werden. Dies erfordert herkömmlich eine Umverdrahtung im Sinne eines händischen Eingriffs, mit dem elektrisch leitende Verbindungen anders angeschlossen werden müssen, um einen Abschnitt der Transformatorprüfung auszuführen, bei dem eine Wicklung kurzgeschlossen ist. Dies führt zu zusätzlichem Arbeits- und Zeitaufwand. Insbesondere bei Transformatoren, wie sie in Kraftwerken oder Umspannwerken verwendet werden, können diese Umverdrahtungen sehr aufwändig sein. Häufig werden Leitern oder Steiger benötigt.

### ZUSAMMENFASSUNG DER ERFINDUNG

Es besteht ein Bedarf an Vorrichtungen und Verfahren, mit denen eine Transformatorprüfung weiter automatisiert werden kann. Es besteht insbesondere ein Bedarf an Vorrichtungen und Verfahren, mit denen eine Transformatorprüfung weiter automatisiert werden kann und der mit Umverdrahtungen verbundene Arbeitsaufwand verringert werden kann.

Erfindungsgemäß werden eine Transformatorprüfvorrichtung und ein Verfahren zum Prüfen eines Transformators angegeben, bei denen die Transformatorprüfvorrichtung eingerichtet ist, um wenigstens eine Wicklung des Transformators kurzzuschließen. Die Transformatorprüfvorrichtung kann ein steuerbares Schaltmittel umfassen, das betätigt wird, um einen Kurzschlussstrom vom Transformator durch das steuerbare Schaltmittel der Transformatorprüfvorrichtung fließen zu lassen.

Bei der Transformatorprüfvorrichtung und dem Verfahren nach Ausführungsbeispielen kann die wenigstens eine Wicklung während eines Teils einer Transformatorprüfung kurzgeschlossen werden. Die wenigstens eine Wicklung kann während der gesamten Transformatorprüfung kurzgeschlossen werden. Das steuerbare Schaltmittel kann bei Ausführung der Transformatorprüfung automatisch so angesteuert werden, dass zeitabhängig das Fließen eines Kurzschlussstroms durch die Transformatorprüfung erlaubt wird. Das steuerbare Schaltmittel kann bei Ausführung der Transformatorprüfung automatisch so angesteuert werden, dass zeitabhängig das Fließen eines Kurzschlussstroms durch die Transformatorprüfung erlaubt und dann wieder unterbunden wird, um unterschiedliche Messungen auszuführen.

Die Transformatorprüfvorrichtung hat Anschlüsse, die mit einer Unterspannungsseite des Transformators zu verbinden sind. Die Transformatorprüfvorrichtung kann so eingerichtet sein, dass das steuerbare Schaltmittel den Widerstand zwischen wenigstens zwei der mit der Unterspannungsseite zu verbindenden Anschlüssen verringert, um die wenigstens eine Wicklung an der Unterspannungsseite des Transformators kurzzuschließen. Die Transformatorprüfvorrichtung kann eingerichtet sein, um alternativ oder zusätzlich zur Unterspannungsseite die Oberspannungsseite oder eine Tertiärwicklung des Transformators mit dem steuerbaren Schaltmittel kurzzuschließen. Die Transformatorprüfvorrichtung kann eingerichtet sein, um Kombinationen von zwei Wicklungen kurzzuschließen. Beispielsweise kann die Transformatorprüfvorrichtung eingerichtet sein, um zwei von drei Wicklungen eines Transformators automatisch kurzzuschließen.

Unter einem Kurzschließen wird hier die Herstellung eines elektrisch leitenden Pfads mit einem geringen Widerstand verstanden. Der elektrisch leitende Pfad kann nahe an der Wicklung des Transformators eine nahezu perfekte elektrische Verbindung herstellen. Es kann auch eine Strommesseinrichtung, beispielsweise ein Amperemeter, in den Pfad über Verbindungsleitungen eingeschleift sein. Durch Leitungswiderstände und den Innenwiderstand des Amperemeters ist der Kurzschluss zwar nicht perfekt, aber kann deutlich von einem Leerlauf oder einem Leerlauf mit angeschlossenem Voltmeter unterschieden werden.

Die Transformatorprüfvorrichtung ist eingerichtet, um automatisch während eines Prüfablaufs den Kurzschluss zeitweise anzulegen und zeitweise den Kurzschluss zu öffnen. So kann beispielsweise eine Quelle für ein Prüfsignal an der Primärwicklung des Transformators eine Wechselspannung anlegen und dann, wenn auf der Sekundärseite der Kurzschluss erzeugt ist, eine Kurzschlussimpedanz messen. Wenn der Kurzschluss unterbrochen ist, kann durch Messung der Spannung auf Primär- und Sekundärseite das Übersetzungsverhältnis des Transformators.

Der Kurzschluss kann von der Transformatorprüfvorrichtung an der Unterspannungsseite oder Sekundärseite des Transformators hergestellt werden. Transformatorprüfvorrichtungen und Verfahren nach Ausführungsbeispielen erlauben die Durchführung von Messungen, bei denen wenigstens eine Wicklung während wenigstens eines Teils der Transformatorprüfung kurzgeschlossen wird, ohne dass dafür spezifisch die Verbindungen zwischen dem Transformator und der Transformatorprüfvorrichtung geändert werden müssen. Der mit Umverdrahtungen verbundene Arbeitsaufwand kann verringert oder beseitigt werden.

Eine Transformatorprüfvorrichtung zum Prüfen eines Transformators nach der Erfindung umfasst Anschlüsse zur lösbaren Verbindung der Transformatorprüfvorrichtung mit dem Transformator. Die Transformatorprüfvorrichtung umfasst eine Quelle zum Erzeugen eines Prüfsignals zum Prüfen des Transformators. Die Transformatorprüfvorrichtung umfasst ein steuerbares Schaltmittel, das zum Kurzschließen wenigstens einer Wicklung des Transformators bei einer Transformatorprüfung mit den Anschlüssen verbunden ist.

Die Transformatorprüfvorrichtung umfasst eine Steuereinrichtung, die mit dem steuerbaren Schaltmittel verbunden ist. Die Steuereinrichtung ist eingerichtet, um das steuerbare Schaltmittel zur Durchführung der Transformatorprüfung wenigstens einmal automatisch zu betätigen. Die Steuereinrichtung kann eine oder mehrere integrierte Halbleitschaltungen umfassen.

Die Steuereinrichtung ist eingerichtet, um das steuerbare Schaltmittel gemäß einem Zeitablaufplan, der von einer ausgewählten Prüfungsprozedur abhängt, automatisch zeitabhängig anzusteuern.

Die Transformatorprüfvorrichtung kann eine Benutzerschnittstelle zum Auswählen der Prüfungsprozedur aus einer Mehrzahl von Prüfungsprozeduren umfassen.

Die Steuereinrichtung ist eingerichtet um das steuerbare Schaltmittel und die Quelle gemäß dem Zeitablaufplan zeitabhängig anzusteuern.

Die Transformatorprüfvorrichtung kann als ein mobiles Transformatorprüfgerät ausgestaltet sein. Die Transformatorprüfvorrichtung kann als ein portables Transformatorprüfgerät ausgestaltet sein. Die Transformatorprüfvorrichtung kann ein Gehäuse umfassen, in dem die Quelle und das steuerbare Schaltmittel untergebracht sind. Die Anschlüsse können an dem Gehäuse vorgesehen sein.

Das steuerbare Schaltmittel kann im Inneren des Gehäuses angeordnet sein.

Das steuerbare Schaltmittel kann zum Leiten eines Kurzschlussstroms bei der Transformatorprüfung eingerichtet sein.

Die Transformatorprüfvorrichtung kann eine Strommesseinrichtung, beispielsweise ein Amperemeter, umfassen, das mit dem steuerbaren Schaltmittel in Reihe geschaltet ist.

Die Transformatorprüfvorrichtung kann eingerichtet sein, um die wenigstens eine Wicklung während eines Teils einer Zeitdauer der Transformatorprüfung kurzzuschließen. Während der Transformatorprüfung kann der Kurzschluss zeitabhängig hergestellt und aufgehoben werden.

Die Transformatorprüfvorrichtung kann eingerichtet sein, um die wenigstens eine Wicklung während einer gesamten Zeitdauer der Transformatorprüfung kurzzuschließen

Die Transformatorprüfvorrichtung kann eingerichtet sein, um bei der Transformatorprüfung wenigstens eine Widerstandsmessung auszuführen. Alternativ oder zusätzlich kann die Transformatorprüfvorrichtung eingerichtet sein, um bei der Transformatorprüfung wenigstens eine einer Streuimpedanzmessung auszuführen. Alternativ oder zusätzlich kann die Transformatorprüfvorrichtung eingerichtet sein, um bei der Transformatorprüfung wenigstens eine dynamische Widerstandsmessung bei Betätigung eines Stufenschalters auszuführen.

Die Transformatorprüfvorrichtung kann eine Messeinrichtung umfassen, um eine Prüfantwort des Transformators auf das Prüfsignal zu erfassen. Die Messeinrichtung kann ein Voltmeter und/oder ein Amperemeter umfassen. Die Transformatorprüfvorrichtung kann einen Prozessor oder eine andere elektronische Verarbeitungseinrichtung aufweisen, die eingerichtet ist, um eine von der Messeinrichtung während der Transformatorprüfung erfasste Prüfantwort weiter zu verarbeiten.

Das Prüfsignal kann ein Strom sein, der in den Transformator eingeprägt wird. Die mit der Messeinrichtung erfasste Prüfantwort kann eine Spannung sein, die in einer Vierpunkt-Messung erfasst wird.

Das Prüfsignal kann eine Spannung sein, die an den Transformator angelegt wird. Die mit der Messeinrichtung erfasste Prüfantwort kann ein Strom sein.

Die Transformatorprüfvorrichtung kann eingerichtet sein, um für eine statische Widerstandsmessung die wenigstens eine Wicklung nicht kurzzuschließen, bis ein Kern des Transformators in Sättigung gegangen ist. Die Transformatorprüfvorrichtung kann eingerichtet sein, um durch Betätigung des steuerbaren Schalters die wenigstens eine Wicklung anschließend kurzzuschließen, um die Widerstandsmessung auszuführen.

Die Transformatorprüfvorrichtung kann eingerichtet sein, um einen Wicklungswiderstand des Transformators zu messen.

Die Transformatorprüfvorrichtung kann eingerichtet sein, eine Messung an dem Transformator bei einer Betätigung eines Stufenschalters des Transformators auszuführen. Die Messung kann eine dynamische Widerstandsmessung während eines Schaltvorgangs des Stufenschalters sein. Dabei kann die Transformatorprüfvorrichtung eine Veränderung von Strom, Spannung und/oder Widerstand während des Schaltens des Stufenschalters erfassen. Vorteilhaft kann die Transformatorprüfvorrichtung eingerichtet sein, um den Transformator an einer anderen Wicklung als der Stufenschalterwicklung kurzzuschließen, um die Veränderungen der elektrischen Größen zu verstärken.

Die Quelle der Transformatorprüfvorrichtung kann so ausgestaltet sein, dass sie selektiv als Stromquelle oder als Spannungsquelle betreibbar ist.

Die Quelle kann eine Strommesseinrichtung umfassen. Die Quelle kann eingerichtet sein, um ein Ausgangssignal der Strommesseinrichtung in einer Regelschleife für eine Stromregelung zu verwenden. Alternativ oder zusätzlich kann eine Strommesseinrichtung mit der Quelle in Serie geschaltet sein.

Das steuerbare Schaltmittel kann ein Relais sein oder kann ein Relais umfassen. Das steuerbare Schaltmittel kann ein Bipolartransistor mit isolierter Gate-Elektrode (IGBT) oder ein Feldeffekttransistor (FET) sein oder kann einen IGBT oder einen FET umfassen.

Ein System nach einem Ausführungsbeispiel umfasst einen Transformator und eine Transformatorprüfvorrichtung nach einem Ausführungsbeispiel, die über die Anschlüsse lösbar mit dem Transformator verbunden ist.

Die Transformatorprüfvorrichtung kann so mit dem Transformator verbunden sein, dass über den steuerbaren Schalter der Transformatorprüfvorrichtung wenigstens eine Wicklung an der Unterspannungsseite oder Sekundärseite des Transformators kurzschließbar ist.

Nach einem weiteren Ausführungsbeispiel wird ein Verfahren zum Prüfen eines Transformators mit einer Transformatorprüfvorrichtung angegeben. Die Transformatorprüfvorrichtung weist Anschlüsse zur lösbaren Verbindung der Transformatorprüfvorrichtung mit dem Transformator auf. Das Verfahren umfasst ein Kurzschließen wenigstens einer Wicklung des Transformators mit einem steuerbaren Schaltmittel der Transformatorprüfvorrichtung.

Das Verfahren kann von der Transformatorprüfvorrichtung nach einem Ausführungsbeispiel ausgeführt werden. Das Verfahren kann von der Transformatorprüfvorrichtung nach einem Ausführungsbeispiel automatisch ausgeführt werden.

Bei dem Verfahren kann eine Steuereinrichtung, die mit dem steuerbaren Schaltmittel verbunden ist, das steuerbare Schaltmittel zur Durchführung der Transformatorprüfung wenigstens einmal automatisch zu betätigen.

Bei dem Verfahren kann das steuerbare Schaltmittel gemäß einem Zeitablaufplan, der von einer ausgewählten Prüfungsprozedur abhängt, automatisch zeitabhängig angesteuert werden.

Das Verfahren kann das Erfassen einer Benutzereingabe an einer Benutzerschnittstelle umfassen, mit der die Prüfungsprozedur aus einer Mehrzahl von Prüfungsprozeduren ausgewählt wird.

Bei dem Verfahren können das steuerbare Schaltmittel und die Quelle gemäß dem Zeitablaufplan zeitabhängig angesteuert werden.

Das Verfahren kann von einer Transformatorprüfvorrichtung ausgeführt werden, die als ein mobiles Transformatorprüfgerät ausgestaltet ist.

Das Verfahren kann von einer Transformatorprüfvorrichtung ausgeführt werden, die als ein portables Transformatorprüfgerät ausgestaltet ist.

Das steuerbare Schaltmittel, das bei dem Verfahren geschaltet wird, kann in einem Inneren eines Gehäuses der Transformatorprüfvorrichtung angeordnet sein. In dem Gehäuse kann auch die Quelle angeordnet sein.

Bei dem Verfahren kann das steuerbare Schaltmittel einen Kurzschlussstrom bei der Transformatorprüfung leiten.

Bei dem Verfahren kann die wenigstens eine Wicklung während eines Teils einer Zeitdauer der Transformatorprüfung kurzgeschlossen werden. Während der Transformatorprüfung kann der Kurzschluss zeitabhängig hergestellt und aufgehoben werden.

Bei dem Verfahren kann die wenigstens eine Wicklung während einer gesamten Zeitdauer der Transformatorprüfung kurzgeschlossen werden.

Das Verfahren kann wenigstens eine Widerstandsmessung umfassen. Alternativ oder zusätzlich kann das Verfahren wenigstens eine Streuimpedanzmessung umfassen. Alternativ oder zusätzlich kann das Verfahren wenigstens eine dynamische Widerstandsmessung umfassen. Alternativ oder zusätzlich kann das Verfahren eine Messung eines Übersetzungsverhältnisses umfassen.

Bei dem Verfahren kann eine Prüfantwort des Transformators auf das Prüfsignal mit einer Messeinrichtung erfasst werden. Die Messeinrichtung kann ein Voltmeter und/oder ein Amperemeter umfassen. Die von der Messeinrichtung während der Transformatorprüfung erfasste Prüfantwort kann automatisch weiter verarbeitet werden.

Das Prüfsignal kann ein Strom sein, der in den Transformator eingeprägt wird. Die mit der Messeinrichtung erfasste Prüfantwort kann eine Spannung sein, die in einer Vierpunkt-Messung erfasst wird.

Das Prüfsignal kann eine Spannung sein, die an den Transformator angelegt wird. Die mit der Messeinrichtung erfasste Prüfantwort kann ein Strom sein.

Bei dem Verfahren kann ein Wicklungswiderstand des Transformators gemessen werden.

Bei dem Verfahren kann eine Messung an dem Transformator bei einer Betätigung eines Stufenschalters des Transformators erfolgen. Die Messung kann eine dynamische Widerstandsmessung während eines Schaltvorgangs des Stufenschalters sein. Dabei kann eine Veränderung von Strom, Spannung und/oder Widerstand während des Schaltens des Stufenschalters erfasst werden. Vorteilhaft kann der Transformator an einer anderen Wicklung als der Stufenschalterwicklung kurzgeschlossen werden, um die Veränderungen der elektrischen Größen zu verstärken.

Das steuerbare Schaltmittel kann ein Relais sein oder kann ein Relais umfassen. Das steuerbare Schaltmittel kann ein Bipolartransistor mit isolierter Gate-Elektrode (IGBT) oder ein Feldeffekttransistor (FET) sein oder kann einen IGBT oder einen FET umfassen.

Bei Transformatorprüfvorrichtungen, Systemen und Verfahren nach Ausführungsbeispielen kann ein Kurzschluss wenigstens während eines Teils der Transformatorprüfung hergestellt werden, ohne dass dazu eine Umverdrahtung vorgenommen werden muss.

Verschiedene Messtechniken können eingesetzt werden. Mit einem auf der Primärseite des Transformators eingeprägten Strom und einer kurzgeschlossenen Sekundärwicklung kann beispielsweise besonders gut eine Messung der Kurzschlussimpedanz des Transformators erfolgen. Mit einer angelegten Spannung auf der Primärseite und entferntem Kurzschluss auf der Sekundärseite kann besonders vorteilhaft das Übersetzungsverhältnis gemessen werden.

Transformatorprüfvorrichtungen, Verfahren und Systeme nach Ausführungsbeispielen erlauben eine weitergehende Automatisierung von Transformatorprüfungen.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt ein System mit einer Transformatorprüfvorrichtung nach einem Ausführungsbeispiel.
Figur 2 zeigt ein System mit einer Transformatorprüfvorrichtung nach einem Ausführungsbeispiel.
Figur 3 zeigt ein System mit einer Transformatorprüfvorrichtung nach einem Ausführungsbeispiel.
Figur 4 ist ein Flussdiagramm eines Verfahrens nach einem Ausführungsbeispiel.
Figur 5 veranschaulicht einen durch eine Transformatorprüfvorrichtung nach einem Ausführungsbeispiel zeitabhängig erzeugten Kurzschluss.
Figur 6 veranschaulicht einen durch eine Transformatorprüfvorrichtung nach einem Ausführungsbeispiel zeitabhängig erzeugten Kurzschluss.
Figur 7 zeigt ein System mit einer Transformatorprüfvorrichtung nach einem Ausführungsbeispiel.
Figur 8 ist ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren zur Durchführung einer Transformatorprüfung mit einer Transformatorprüfvorrichtung detailliert beschrieben. Der Transformator kann ein Transformator für Hoch- oder Mittelspannungsnetze sein. Der Transformator kann ein in einem Kraftwerk oder Umspannwerk installierter Transformator sein. Die Transformatorprüfvorrichtung kann ein mobiles Gerät sein, das die Durchführung der Transformatorprüfung an dem installierten Transformator erlaubt.

Die Transformatorprüfvorrichtung ist eingerichtet, um mit einer ersten Wicklung und einer davon galvanisch getrennten zweiten Wicklung des Transformators verbunden zu werden. Die erste Wicklung kann eine Primärwicklung sein. Die zweite Wicklung kann eine Sekundärwicklung sein. Die Primärwicklung kann eine Wicklung an einer Oberspannungsseite und die Sekundärwicklung kann eine Wicklung an einer Unterspannungsseite des Transformators sein. Die zweite Wicklung kann eine Tertiärwicklung des Transformators sein.

Die Transformatorprüfvorrichtung kann erste Anschlüsse umfassen, mit denen die Transformatorprüfvorrichtung über vier elektrisch leitende Verbindungen mit der ersten Wicklung des Transformators verbindbar ist. Dies erlaubt beispielsweise die Durchführung von Impedanzmessungen mit einer Vierpunkt-Messgeometrie, bei der ein Strom eingeprägt und ein Spannungsabfall erfasst wird. Die Transformatorprüfvorrichtung kann zweite Anschlüsse umfassen, mit denen die Transformatorprüfvorrichtung über vier weitere elektrisch leitende Verbindungen mit der zweiten Wicklung des Transformators verbindbar ist.

Wie nachfolgend ausführlicher beschrieben wird, ist die Transformatorprüfvorrichtung eingerichtet, um wenigstens eine der Wicklungen des Transformators kurzzuschlie-ßen. Die Transformatorprüfvorrichtung umfasst ein steuerbares Schaltmittel, mit dem eine elektrisch leitende Verbindung zum Kurzschließen der wenigstens einen Wicklung selektiv hergestellt werden kann. Das steuerbare Schaltmittel kann ein Relais oder ein anderer Schalter, der zum Schalten eines Lastkreises unter Kontrolle eines Steuerkreises eingerichtet ist, sein. Das steuerbare Schaltmittel kann ein Bipolartransistor mit isolierter Gate-Elektrode (IGBT) oder ein Feldeffekttransistor (FET) sein oder kann einen IGBT oder einen FET umfassen.

Durch das steuerbare Schaltmittel kann ein Kurzschlussstrom von der wenigstens einen Wicklung des Transformators durch die Transformatorprüfvorrichtung fließen.

Die Transformatorprüfvorrichtung kann so eingerichtet sein, dass eine Impedanz eines elektrisch leitenden Pfads in der Transformatorprüfvorrichtung, der zwei der Anschlüsse der Transformatorprüfvorrichtung über das steuerbare Schaltmittel verbindet, kleiner ist als eine Impedanz der wenigstens einen Wicklung, die durch die Transformatorprüfvorrichtung kurzgeschlossen werden kann, wenn das steuerbare Schaltmittel zum Kurzschließen der wenigstens einen Wicklung betätigt wird. Das entsprechende Verhältnis der Impedanzen kann wenigstens für die Frequenz des durch die Transformatorprüfvorrichtung erzeugten Prüfsignals bestehen, das von einer Quelle der Transformatorprüfvorrichtung erzeugt wird, während die Transformatorprüfvorrichtung die wenigstens eine Wicklung kurzschließt.

Die Transformatorprüfvorrichtung kann so eingerichtet sein, dass eine Impedanz eines elektrisch leitenden Pfads von der wenigstens einen Wicklung über die Transformatorprüfvorrichtung kleiner ist als eine Impedanz der wenigstens einen Wicklung, die durch die Transformatorprüfvorrichtung kurzgeschlossen werden kann.

Die Impedanz des leitenden Pfads in der Transformatorprüfvorrichtung, der zwei der Anschlüsse der Transformatorprüfvorrichtung über das steuerbare Schaltmittel verbindet, muss nicht gleich Null sein. Beispielsweise kann ein Amperemeter oder eine andere Messeinrichtung in dem elektrisch leitenden Pfad angeordnet sein.

Das steuerbare Schaltmittel kann automatisch angesteuert werden, um für unterschiedliche Zeitabschnitte einer Transformatorprüfung selektiv zu kontrollieren, ob die wenigstens eine Wicklung des Transformators kurzgeschlossen werden soll.

Beispielsweise kann die Transformatorprüfvorrichtung eingerichtet sein, um das steuerbare Schaltmittel zu betätigen, um eine Kurzschlussimpedanz zu messen.

Alternativ oder zusätzlich kann die Transformatorprüfvorrichtung eingerichtet sein, um ein Übersetzungsverhältnis des Transformators zu bestimmen, während das steuerbare Schaltmittel keinen Kurzschluss erzeugt.

Alternativ oder zusätzlich kann die Transformatorprüfvorrichtung eingerichtet sein, um das steuerbare Schaltmittel zeitabhängig so zu betätigen, dass die wenigstens eine Wicklung nicht kurzgeschlossen wird, während ein Eisenkern des Transformators durch Einprägen eines Stroms an der Primärwicklung in Sättigung gebracht wird, und dass das steuerbare Schaltmittel betätigt wird, sobald der Eisenkern in Sättigung ist. Anschließend kann eine Messung, beispielsweise eine Messung einer Kurzschlussimpedanz, einer Streuimpedanz oder einer Streuinduktivität, erfolgen.

Alternativ oder zusätzlich kann die Transformatorprüfvorrichtung eingerichtet sein, um das steuerbare Schaltmittel zeitabhängig so zu betätigen, dass während eines Schaltens eines Stufenschalters des Transformators die Sekundärwicklung des Transformators kurzgeschlossen wird.

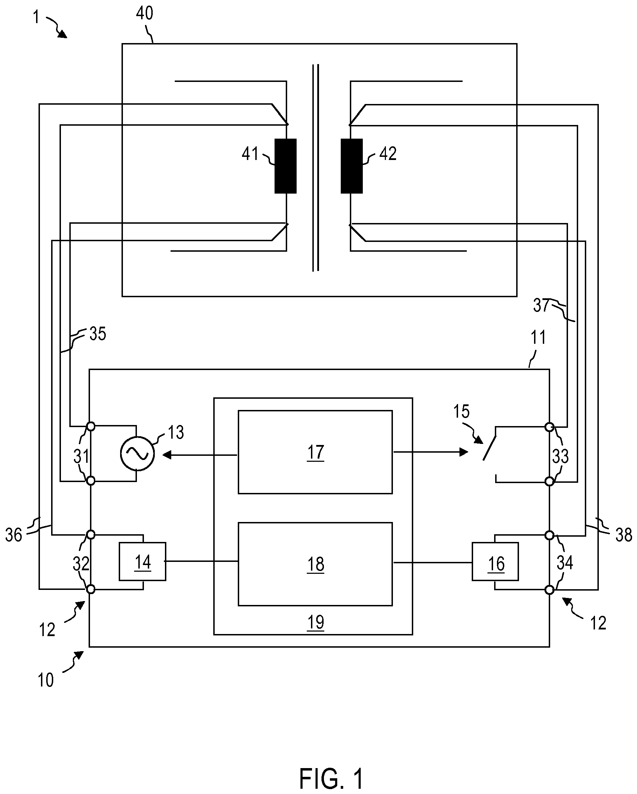

Figur 1 zeigt ein System 1 mit einer Transformatorprüfvorrichtung 10 nach einem Ausführungsbeispiel.

Das System 1 umfasst einen Transformator 40 und die Transformatorprüfvorrichtung 10. Die Transformatorprüfvorrichtung 10 kann als ein einziges Gerät mit einem Gehäuse 11 ausgebildet sein. Die Transformatorprüfvorrichtung 10 kann aus einer Anordnung von mehreren Geräten oder Einrichtungen bestehen. Die mehreren Geräte oder Einrichtungen können in diesem Fall von einer zentralen Steuerung gesteuert werden. Die Transformatorprüfvorrichtung 10 kann als mobiles Gerät und insbesondere als portables Gerät ausgebildet sein. Falls die Transformatorprüfvorrichtung 10 aus mehreren Geräten besteht, kann jedes der Geräte als portables Gerät ausgebildet sein.

Der Transformator 40 kann ein Leistungstransformator einer elektrischen Energieversorgungseinrichtung sein. Der Transformator 40 kann fest in einem Kraftwerk oder Umspannwerk verbaut sein, während mit der Transformatorprüfvorrichtung 10 eine Transformatorprüfung ausgeführt wird. Der Transformator 40 kann ein Spannungswandler oder Stromwandler sein. Der Transformator 40 kann ein Spannungswandler oder Stromwandler sein, der nach induktivem Wirkprinzip arbeitet.

Der Transformator 40 umfasst zumindest eine erste Wicklung 41 und eine zweite Wicklung 42. Es ist nicht erheblich, ob die erste Wicklung 41 die Primärwicklung und die zweite Wicklung 42 die Sekundärwicklung ist oder umgekehrt. Ebenso ist es nicht erheblich, ob die erste Wicklung 41 die Oberspannungswicklung und die zweite Wicklung 42 die Unterspannungswicklung ist oder umgekehrt.

Die Transformatorprüfvorrichtung 10 umfasst mehrere Anschlüsse 12, eine Quelle 13 für ein Prüfsignal, das an den Transformator 40 als Prüfling bei der Transformatorprüfung angelegt oder eingeprägt wird, und ein steuerbares Schaltmittel 15. Das steuerbare Schaltmittel 15 kann beispielsweise ein Relais, ein IGBT oder ein FET sein.

Die Quelle 13 kann eine Stromquelle sein, die steuerbar ist, um einen Gleichstrom und/oder einen Wechselstrom als Prüfsignal zu erzeugen. Die Quelle 13 kann steuerbar sein, um Wechselströme mit mehreren unterschiedlichen Frequenzen als Prüfsignal zu erzeugen. Die Quelle 13 kann eine Spannungsquelle sein, die steuerbar ist, um eine Gleichspannung und/oder eine Wechselspannung als Prüfsignal zu erzeugen. Die Quelle 13 kann steuerbar sein, um Wechselspannungen mit mehreren unterschiedlichen Frequenzen als Prüfsignal zu erzeugen. Die Quelle 13 kann in unterschiedlichen Betriebsmodi betreibbar sein, beispielsweise als Stromquelle oder als Spannungsquelle und/oder als Quelle eines zeitlich konstanten Signals oder eines Wechselsignals. Die Quelle 13 kann eine Strommesseinrichtung umfassen. Die Quelle 13 kann eingerichtet sein, um ein Ausgangssignal der Strommesseinrichtung in einer Regelschleife für eine Stromregelung zu verwenden. Alternativ oder zusätzlich kann eine Strommesseinrichtung mit der Quelle 13 in Serie geschaltet sein.

Die Transformatorprüfvorrichtung 10 kann weitere Einrichtungen umfassen, beispielsweise eine oder mehrere Messeinrichtungen 14, 16 zum Erfassen einer Prüfantwort als Reaktion auf das Prüfsignal. Die Transformatorprüfvorrichtung 10 kann eine Steuereinrichtung 17 zum automatischen elektrischen Steuern des steuerbaren Schaltmittels 15 umfassen. Die Transformatorprüfvorrichtung 10 kann eine Auswerteeinrichtung 18 zum Auswerten einer Prüfantwort des Transformators 40, die mit den Messeinrichtungen 14, 16 erfasst wird, umfassen. Die erste Messeinrichtung 14 und die zweite Messeinrichtung 16 können beispielsweise jeweils für eine Spannungsmessung eingerichtet sein. Die erste Messeinrichtung 14 und die zweite Messeinrichtung 16 können jeweils zur Erfassung anderer elektrischer Kenngrößen eingerichtet sein. Die Funktionen der Steuereinrichtung 17 und/oder der Auswerteeinrichtung 18 können von einem Prozessor 19 oder einer anderen integrierten Halbleitschaltung 19 ausgeführt werden.

Die Quelle 13 kann ein zeitlich veränderliches Prüfsignal erzeugen. Eine Frequenz des Prüfsignals kann zwischen mehreren Werten veränderbar sein. Die erste Messeinrichtung 14 und die zweite Messeinrichtung 16 können zur zeitaufgelösten Erfassung einer Prüfantwort eingerichtet sein. Messwerte, die von der ersten Messeinrichtung 14 und der zweiten Messeinrichtung 16 erfasst werden, können A/D-gewandelt und rechnerisch weiter ausgewertet werden, beispielsweise um Kenngrößen des Transformators für jede von mehreren Frequenzen zu bestimmen.

Die Anschlüsse 12 umfassen Ausgangsanschlüsse 31, die mit der Quelle 13 gekoppelt ist. Der Ausgangsanschlüsse 31 sind über eine oder mehrere Leitungen 35 elektrisch leitend mit der ersten Wicklung 41 des Transformators 40 verbunden.

Die Anschlüsse 12 umfassen Eingangsanschlüsse 32, 34, die mit einer oder mehreren Wicklungen des Transformators über eine oder mehrere Leitungen 36, 38 verbunden sind, um eine Prüfantwort des Transformators 10 zu erfassen. Eine Messeinrichtung 14 kann beispielsweise über von den Leitungen 35 separate weitere Leitungen 37 mit der ersten Wicklung 41 verbunden werden. Die Messeinrichtung 14 kann ein Voltmeter sein. Eine derartige Verbindung zwischen der Transformatorprüfvorrichtung 10 und dem Transformator 40 erlaubt beispielsweise eine Messung nach einer so genannten Vierdrahtmethode. Durch die separate Führung von Spannungsleitungen vom Eingangsanschluss 32 zur ersten Wicklung 41 kann erreicht werden, dass ein Spannungsabfall der Leitung 31 zwischen dem Ausgangsanschluss 31 und der ersten Wicklung 41 das Messergebnis nicht verfälscht.

Die Transformatorprüfvorrichtung 10 umfasst wenigstens ein Paar von Anschlüssen 33, der über das steuerbare Schaltmittel 15 kurzgeschlossen werden kann. Das steuerbare Schaltmittel kann ein konventioneller Schalter, ein mechanisch - elektrischer Schalter, ein Relais, ein FET, ein IGBT oder eine andere Komponente sein, welche geeignet ist, eine elektrisch leitende Verbindung zwischen den Anschlüssen 33 abhängig von einem Zustand des Schaltmittels herzustellen. Der leitende Pfad in der Transformatorprüfvorrichtung 10 zwischen den Anschlüssen 33 weist eine Impedanz auf, die bei wenigstens einer Frequenz oder allen Frequenzen, mit der bzw. mit denen das Prüfsignal von der Quelle 13 erzeugt wird, kleiner ist als eine Impedanz der Wicklung 42, mit der das Paar von Anschlüssen 33 über Leitungen 37 verbunden ist.

Auch die zweite Wicklung 42 kann über wenigstens vier Leitungen 37, 38 mit den Anschlüssen 12 der Transformatorprüfvorrichtung 10 verbunden sein. Die Eingangsanschlüsse 34 können einen Spannungseingang 34 umfassen, der mit einem weiteren Voltmeter verbunden sein kann, um dieses an die zweite Wicklung 42 des Transformators 40 anzuschließen angeschlossen sein kann. Durch die getrennte Führung der Leitungen 37 und 38 kann eine Verfälschung von Messergebnisses durch einen etwaigen Spannungsabfall auf der Leitung 37 zwischen dem paar von Anschlüssen 33 und der zweiten Wicklung 42 verhindert werden.

Der Transformator 40 kann auch mehr als zwei Wicklungen 41, 42 umfassen. Die Transformatorprüfvorrichtung 10 kann Anschlüsse zur Verbindung mit einer dritten Wicklung des Transformators 40 und etwaigen weiteren Wicklungen des Transformators 40 umfassen. Die Transformatorprüfvorrichtung 10 kann Anschlüsse zur Verbindung mit jeder Wicklung des Transformators 40 für eine Vierdrahtmessung umfassen. Die Transformatorprüfvorrichtung 10 kann auch wenigstens einen zweiten steuerbaren Schalter 15 umfassen, um die erste Wicklung 41 oder weitere Wicklungen des Transformators 40 kurzzuschließen, wenn diese mit der Transformatorprüfvorrichtung 10 verbunden sind.

Die Transformatorprüfvorrichtung 10 kann eingerichtet sein, um Kombinationen von zwei Wicklungen kurzzuschließen. Beispielsweise können gleichzeitig oder zeitsequentiell zwei von drei Wicklungen eines Transformators kurzgeschlossen werden. Es können auch Prüfungsprozeduren automatisch gefahren werden, bei denen zunächst jeweils nur eine von mehreren Wicklungen des Transformators kurzgeschlossen wird und anschließend zwei oder mehr als zwei Wicklungen gleichzeitig oder zeitsequentiell kurzgeschlossen werden. Das Kurzschließen kann dabei jeweils durch ein steuerbares Schaltmittel der Transformatorprüfvorrichtung 10 automatisch ausgeführt werden.

Die Transformatorprüfvorrichtung 10 ist so eingerichtet, dass unterschiedliche Messungen erfolgen können, ohne dass die Verbindungen 35-38 zwischen der Transformatorprüfvorrichtung 10 und dem Transformator 40 gelöst und/oder anders angeschlossen werden müssen. Die unterschiedlichen Messungen können ausgeführt werden, ohne dass der Prüfling umverdrahtet werden muss. Die Messungen können von der Transformatorprüfvorrichtung 10 vollständig oder teilweise automatisiert, d.h. ohne Interaktion des Benutzers zwischen den Messungen, durchgeführt werden.

Für wenigstens einen Teil der Messung kann durch das steuerbare Schaltmittel 15 wenigstens eine der Wicklungen des Transformators 40 kurzgeschlossen werden. Beispielsweise kann die Transformatorprüfvorrichtung 10 eine Übersetzungsmessung ausführen. Dazu kann die Quelle 13 als Wechselspannungsquelle betrieben werden. Der Schalter 15 kann geöffnet sein. Eine Spannung an der ersten Wicklung 41 kann mit der ersten Messeinrichtung 14 erfasst werden. Eine Spannung an der zweiten Wicklung 42 kann mit der zweiten Messeinrichtung 16 erfasst werden. Aus einem Verhältnis der Spannungen kann das Übersetzungsverhältnis von der Transformatorprüfvorrichtung 10 bestimmt werden.

Die Transformatorprüfvorrichtung 10 kann alternativ oder zusätzlich eingerichtet sein, um eine Kurzschlussimpedanzmessung auszuführen. Dazu kann die Quelle 13 als Wechselstromquelle betrieben werden. Der Schalter 15 kann geschlossen werden. Dies kann durch ein Steuersignal der Steuereinrichtung 17 geschehen. Die Spannung an der ersten Wicklung 41 kann mit der ersten Messeinrichtung 14 erfasst werden. Durch ein (in Figur 1 nicht dargestelltes) Amperemeter kann optional ein Strom in der zweiten Wicklung 42 erfasst werden. Der erfasste Strom in der zweiten Wicklung 42 kann von der Auswerteeinrichtung 18 für Korrekturzwecke verwendet werden. Beispielsweise kann ein Fehler, der durch einen Widerstand der Leitungen 37, 38 von der zweiten Wicklung 42 zur Prüfvorrichtung 10 entsteht, wenigstens teilweise korrigiert werden.

Die Transformatorprüfvorrichtung 10 kann alternativ oder zusätzlich eingerichtet sein, um eine Wicklungswiderstandsmessung auszuführen. Die Widerstandsmessung kann eine statische Widerstandsmessung sein. Es kann der Wicklungswiderstand der ersten Wicklung 41 bestimmt werden. Zur Bestimmung des Wicklungswiderstands kann die Quelle 13 als Gleichstromquelle arbeiten. Die Spannung an der ersten Wicklung 41 kann von der ersten Messeinrichtung 14 gemessen werden. Der Gleichstrom kann eingeprägt werden, bis ein Eisenkern des Transformators 40 in Sättigung geht. In diesem Zeitabschnitt der Messung kann das steuerbare Schaltmittel 15 geöffnet sein, um schneller den Zustand zu erreichen, in dem der Eisenkern gesättigt ist. Das steuerbare Schaltmittel 15 kann so gesteuert werden, dass es geschlossen wird, um die zweite Wicklung 42 kurzzuschließen, wenn nach Sättigung des Transformatorkerns eine Wicklungswiderstandsmessung, eine Kurzschlussimpedanzmessung, eine Streuimpedanzmessung oder andere Messungen ausgeführt werden. Es kann jeweils auch eine Spannung an der zweiten Wicklung 42 mit der zweiten Messeinrichtung 16 gemessen und zur Korrektur von Fehlern, beispielsweise aufgrund von Leitungswiderständen, verwendet werden.

Die Transformatorprüfvorrichtung 10 kann alternativ oder zusätzlich eingerichtet sein, um ein Verhalten des Transformators 30 im Moment des Umschaltens des Übersetzungsverhältnisses zu erfassen. Eine derartige Messung wird auch als dynamische Widerstandsmessung bezeichnet. Zur Messung des dynamischen Widerstandsverhältnisses kann der steuerbare Schalter 15 jeweils wenigstens dann geschlossen werden, wenn der Umschaltvorgang des Übersetzungsverhältnisses erfolgt. Dadurch können die an der ersten Wicklung 14 erfassten Effekte, die durch den Umschaltvorgang verursacht werden, verstärkt werden.

Mehrere der genannten Messungen oder davon verschiedene weitere Messungen können von der Transformatorprüfvorrichtung 10 ausgeführt werden, ohne dass die Verbindungen zwischen der Transformatorprüfvorrichtung 10 und dem Transformator 40 dazu durch einen Benutzereingriff verändert werden müssen. Insbesondere können die mehreren Messungen ausgeführt werden, ohne dass die Anschlusspunkte der Verbindungen 35-38 am Transformator 40 und an den Anschlüssen 12 der Transformatorprüfvorrichtung 10 geändert werden müssen.

Die Steuereinrichtung 17 kann eingerichtet sein, um das steuerbare Schaltmittel 15 elektrisch anzusteuern. Die Steuereinrichtung 17 kann das steuerbare Schaltmittel 15 während eines Teils einer Transformatorprüfung oder während der gesamten Transformatorprüfung in einen geschlossenen Zustand schalten, um die zweite Wicklung 42 kurzzuschließen.

Die Transformatorprüfvorrichtung 10 kann eingerichtet sein, um mehrere unterschiedliche Messungen sequentiell auszuführen, wobei die Messungen und optional auch ihre Reihenfolge benutzerdefiniert festgelegt werden können. Die Transformatorprüfvorrichtung 10 kann eine grafische Benutzerschnittstelle umfassen, mit der benutzerdefiniert festlegbar ist, welche Messungen ausgeführt werden. Abhängig von einer Benutzereingabe, die die auszuführenden Messungen bestimmt, kann das steuerbare Schaltmittel 15 und die Quelle 13 zeitabhängig so gesteuert werden, dass die ausgewählten Messungen ausgeführt werden. Es kann auch nur eine einzige Messung, beispielsweise eine Messung des Übersetzungsverhältnisses oder eine Wicklungswiderstandsmessung oder eine Streuimpedanzmessung ausgewählt werden. Die Transformatorprüfvorrichtung 10 schaltet dann das steuerbare Schaltmittel 15 gemäß der ausgewählten Messung.

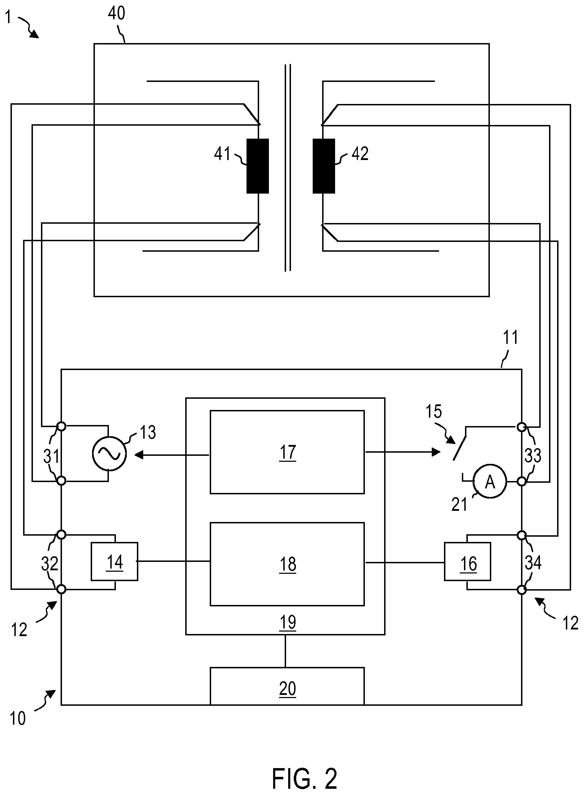

Figur 2 ist eine Darstellung eines Systems 1 mit einer Transformatorprüfvorrichtung 10 nach einem weiteren Ausführungsbeispiel. Die Transformatorprüfvorrichtung 10 umfasst eine grafische Benutzerschnittstelle 20. Die grafische Benutzerschnittstelle 20 kann eingerichtet sein, um eine benutzerdefinierte Festlegung von Messungen zu erlauben, die mit der Transformatorprüfvorrichtung 10 ausgeführt werden. Das steuerbare Schaltmittel 15 kann einmal oder mehrfach während der Transformatorprüfung geschaltet werden. Das Schalten des steuerbaren Schaltmittels 15 kann unter Kontrolle der Steuereinrichtung 17 automatisch erfolgen, ohne nach einem Start der Transformatorprüfung hierfür eine Benutzereingabe oder andere Benutzerhandlung zu benötigen.

Die in Figur 2 dargestellte Transformatorprüfvorrichtung 10 weist auch ein Amperemeter 21 auf, das mit dem steuerbaren Schaltmittel 15 in Reihe geschaltet ist. Das Amperemeter 21 kann einen Innenwiderstand aufweisen, der viel kleiner ist als eine Impedanz der zweiten Wicklung 42, mit der die Anschlüsse 33 verbunden sind. Ein Ausgangssignal des Amperemeters 21 kann von der Auswerteeinrichtung 18 ausgewertet werden, beispielsweise um eine Korrektur der mit den Messeinrichtungen 14, 16 erfassten Spannungen vorzunehmen.

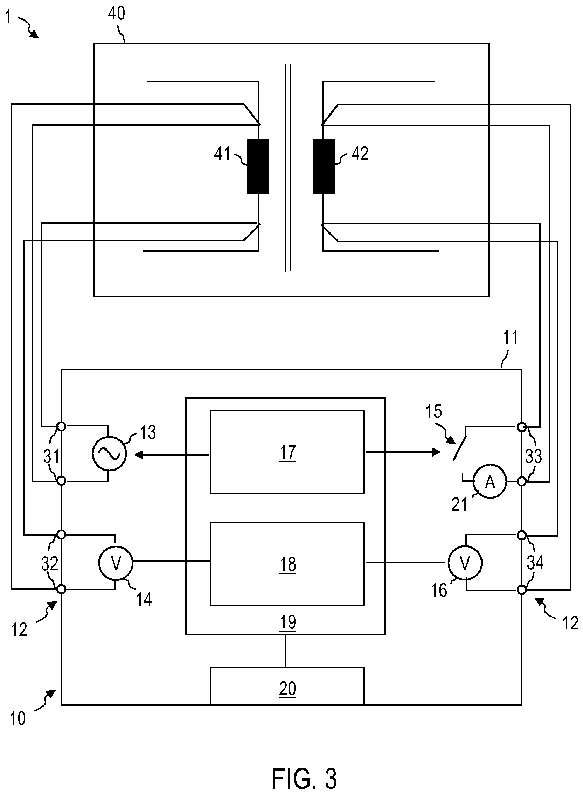

Figur 3 ist eine Darstellung eines Systems 1 mit einer Transformatorprüfvorrichtung 10 nach einem weiteren Ausführungsbeispiel. Bei der Transformatorprüfvorrichtung 10 sind die Messeinrichtungen 14, 16 als Voltmeter ausgestaltet, um eine an der ersten Wicklung 41 und der zweiten Wicklung 42 abfallende Spannung zu erfassen. Andere Ausgestaltungen der Messeinrichtungen 14, 16 können verwendet werden.

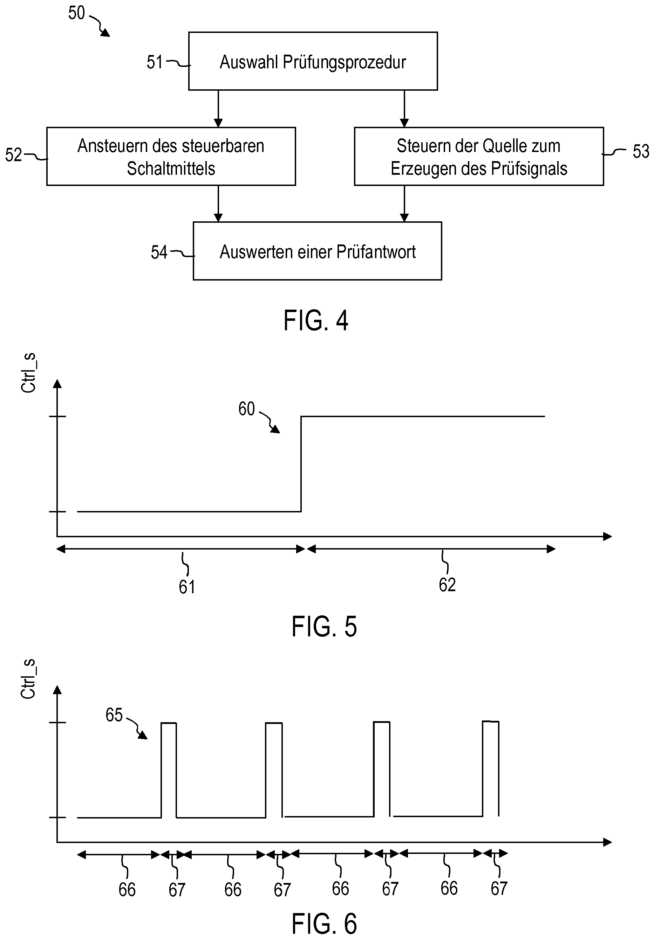

Figur 4 ist ein Flussdiagramm eines Verfahrens 50 nach einem Ausführungsbeispiel. Das Verfahren 50 kann von der Transformatorprüfvorrichtung 10 nach einem Ausführungsbeispiel automatisch ausgeführt werden.

Bei Schritt 51 kann eine Auswahl einer Prüfungsprozedur erfolgen. Die Prüfungsprozedur kann eine oder mehrere Messungen umfassen, die an dem Transformator 40 ausgeführt werden. Die Prüfungsprozedur kann benutzerdefiniert aus einer Mehrzahl von Prüfungsprozeduren ausgewählt werden.

Bei Schritt 52 wird das steuerbare Schaltmittel 15 abhängig von der ausgewählten Prüfungsprozedur gesteuert. Das steuerbare Schaltmittel 15 kann automatisch so gesteuert werden, dass eine Wicklung des Transformators 40 während der gesamten Prüfungsprozedur oder während eines Teils der Prüfungsprozedur kurzgeschlossen wird. Ein Kurzschlussstrom der Wicklung fließt über die Transformatorprüfvorrichtung 10.

Bei Schritt 53 wird die Quelle zum Erzeugen des Prüfsignals gesteuert. Die Quelle kann so gesteuert werden, dass sie wahlweise einen Gleichstrom, eine Gleichspannung oder eine Wechselspannung erzeugt. Es können auch zeitabhängig unterschiedliche Prüfsignale erzeugt werden.

Die Ansteuerung der Quelle und die Ansteuerung des steuerbaren Schalters können zeitlich miteinander koordiniert werden. Beispielsweise kann in einem Teil einer Prüfungsprozedur, in der ein Transformatorkern in Sättigung übergehen soll, das steuerbare Schaltmittel jeweils so gesteuert werden, dass die zweite Wicklung 42 nicht kurzgeschlossen wird, während die Quelle einen Gleichstrom an der ersten Wicklung 41 einprägt.

Bei Schritt 54 kann eine Prüfantwort des Transformators 40 automatisch ausgewertet werden. Die Auswertung kann die Bestimmung eines Wicklungswiderstands bei einer statischen Widerstandsmessung, die Bestimmung einer Streuimpedanz, die Bestimmung einer Streuinduktivität, die Bestimmung eines Übersetzungsverhältnisses oder die Bestimmung einer Kombination von zwei oder mehr als zwei dieser Kenngrößen umfassen.

Während der Prüfungsprozedur kann das steuerbare Schaltmittel 15 einmal oder mehrfach geschaltet werden.

Figur 5 und Figur 6 veranschaulichen beispielhaft ein Steuersignal Ctrl_s zum Steuern des steuerbaren Schaltmittels 15 während einer Prüfungsprozedur. Das Steuersignal kann von einer integrierten Halbleiterschaltung der Transformatorprüfvorrichtung 10 automatisch erzeugt werden. Das Steuersignal kann von einer integrierten Halbleiterschaltung der Transformatorprüfvorrichtung 10 gemäß einem Zeitablaufplan oder abhängig von einem Ausgangssignal wenigstens einer der Messeinrichtungen 14, 16, 21 der Transformatorprüfvorrichtung 10 automatisch erzeugt werden.

Figur 5 veranschaulicht ein Steuersignal 60 zum Ansteuern des steuerbaren Schaltmittels 15 bei einer Prüfungsprozedur, die von der Transformatorprüfvorrichtung 10 ausgeführt werden kann. In einem Teil 61 der Zeitdauer der Prüfungsprozedur hat das Steuersignal 60 einen ersten Wert und das steuerbare Schaltmittel 15 offen, so dass das steuerbare Schaltmittel 15 die Wicklung 42 nicht kurzschließt. Zu einem Zeitpunkt während der Prüfungsprozedur wird das steuerbare Schaltmittel 15 in den geschlossenen Zustand geschaltet, um die zweite Wicklung 42 kurzzuschließen. Das Steuersignal 60 wird dazu auf einen zweiten Wert geändert. In einem zweiten Teil 62 der Zeitdauer der Prüfungsprozedur ist das steuerbare Schaltmittel geschlossen, um die zweite Wicklung 42 kurzzuschließen.

Der Zeitpunkt, zu dem das steuerbare Schaltmittel 15 geschlossen wird, kann beispielsweise durch einen Zeitablaufplan festgelegt sein oder kann von einer Bedingung abhängen. Beispielsweise kann eine Sättigung des Transformatorkerns überwacht werden. Das steuerbare Schaltmittel 15 kann geschlossen werden, wenn der Transformatorkern vollständig gesättigt ist oder wenn die Sättigung ein vorgegebenes Kriterium erfüllt.

Figur 6 veranschaulicht ein Steuersignal 65 zum Ansteuern des steuerbaren Schaltmittels 15 bei einer Prüfungsprozedur, die von der Transformatorprüfvorrichtung 10 ausgeführt werden kann. Das steuerbare Schaltmittel 15 wird mehrfach in den geschlossenen und den offenen Zustand geschaltet, während die Prüfungsprozedur ausgeführt wird. Beispielsweise kann in einem Teil 66 der Prüfungsprozedur das steuerbare Schaltmittel 15 jeweils offen sein, so dass die zweite Wicklung 42 nicht kurzgeschlossen ist. In einem anderen Teil 67 der Prüfungsprozedur kann das steuerbare Schaltmittel 15 jeweils geschlossen sein, so dass die zweite Wicklung 42 kurzgeschlossen ist.

Der Zeitpunkt, zu dem das steuerbare Schaltmittel 15 jeweils geschlossen und geöffnet wird, kann beispielsweise durch einen Zeitablaufplan festgelegt sein oder kann von einer Bedingung abhängen, wie unter Bezugnahme auf Figur 5 beschrieben wurde.

Wenn die Transformatorprüfvorrichtung 10 eingerichtet ist, um mehrere Wicklungen des Transformators zeitsequentiell oder simultan kurzzuschließen, kann die Transformatorprüfvorrichtung 10 mehrere steuerbare Schaltmittel umfassen. Die Steuersignale für die mehreren steuerbaren Schaltmittel können zeitlich koordiniert erzeugt werden, um eine Prüfungsprozedur zu fahren, in der wahlweise eine Wicklung oder mehrere Wicklungen des Transformators kurzgeschlossen werden, ohne dass hierzu eine Umverdrahtung vorgenommen werden muss.

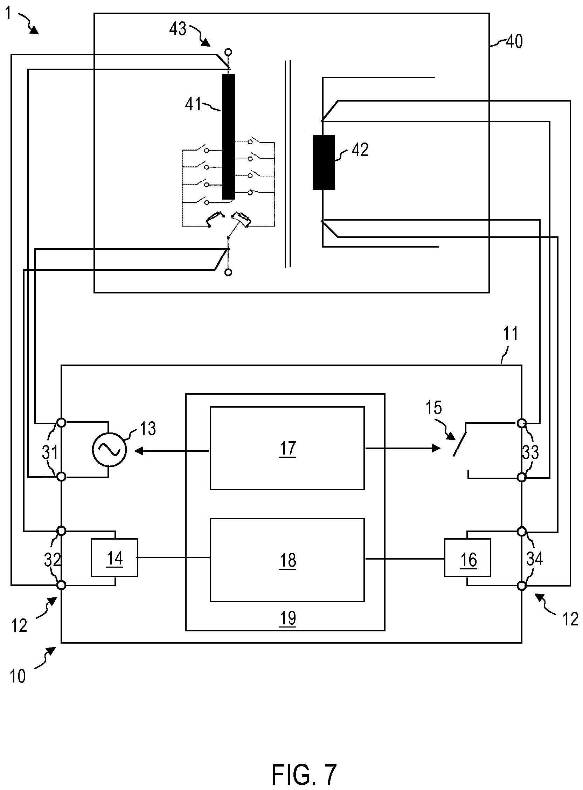

Figur 7 ist eine Darstellung eines Systems 1 mit einer Transformatorprüfvorrichtung 10 nach einem Ausführungsbeispiel. Der Transformator 40 ist so eingerichtet, dass ein Übersetzungsverhältnis verändert werden kann. Dazu kann der Transformator 40 beispielsweise einen Stufenschalter 43 umfassen, der eine erste Wicklung 41 aufweist. Aufbau und Funktionsweise des Stufenschalters 43 sind dem Fachmann bekannt.

Die Transformatorprüfvorrichtung 10 kann eingerichtet sein, um ein Verhalten des Transformators 40 während des Umschaltens des Stufenschalters 43 zu überwachen und auszuwerten. Die Transformatorprüfvorrichtung 10 kann insbesondere für eine dynamische Widerstandsmessung eingerichtet sein. Es kann ein Wicklungswiderstand des Stufenschalters 43 zwischen den zwei Anschlüssen des Stufenschalters beim Umschalten ermittelt werden. Dazu kann von der Quelle 13 ein Gleichstrom oder Wechselstrom eingeprägt und mit der Messeinrichtung 14 eine am Stufenschalter 41 abfallende Spannung erfasst werden.

Das steuerbare Schaltmittel 15 ist eingerichtet, um die zweite Wicklung 42 auf der Seite des Transformators 40, an der kein Stufenschalter vorgesehen ist, selektiv kurzzuschließen. Das steuerbare Schaltmittel 15 kann beim Umschalten des Stufenschalters 41 jeweils geschlossen werden, um die zweite Wicklung 42 kurzzuschlie-ßen. Dadurch können besonders deutliche Effekte beim Umschaltvorgang beobachtet werden. Zwischen zwei Vorgängen kann das steuerbare Schaltmittel 15 jeweils geöffnet werden, so dass die zweite Wicklung 42 nicht kurzgeschlossen ist. Dadurch kann eine raschere Stabilisierung des Verhaltens des Transformators 40 erreicht werden.

Optional kann für jede Schaltstufe des Stufenschalters 41 auch eine statische Widerstandsmessung ausgeführt werden, bei der der Widerstand des Stufenschalters 41 für eine oder mehrere Frequenzen bestimmt wird.

Die Transformatorprüfvorrichtung 10 kann eine Schnittstelle umfassen, um das Schalten des steuerbaren Schaltmittels 15 koordiniert mit Umschaltvorgängen des Stufenschalters 41 auszuführen. Beispielsweise kann die Transformatorprüfvorrichtung 10 eingerichtet sein, um Umschaltvorgänge des Stufenschalters 41 auszulösen. Alternativ oder zusätzlich kann ein Beginn eines Umschaltvorgangs von der Transformatorprüfvorrichtung 10 durch Überwachung der Spannung am Stufenschalter automatisch erkannt werden und kann als Auslöser für ein automatisches Schalten des steuerbaren Schaltmittels 15 in den geschlossenen Zustand dienen.

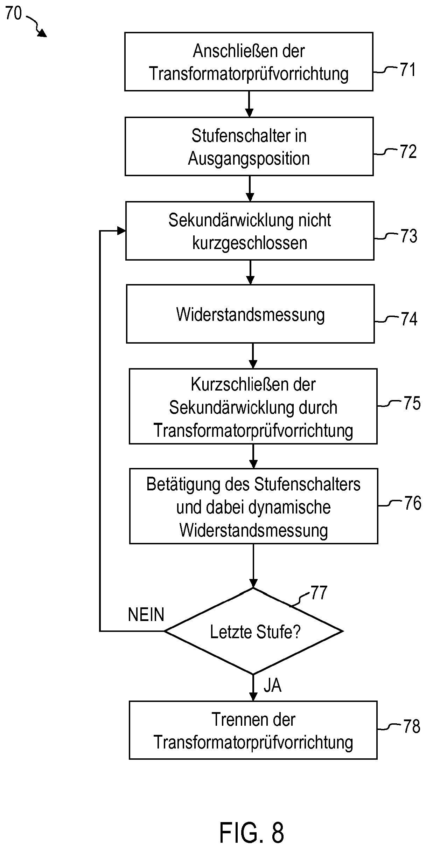

Figur 8 ist ein Flussdiagramm eines Verfahrens 70 nach einem Ausführungsbeispiel. Das Verfahren 70 kann zur Prüfung eines Transformators, der einen Stufenschalter umfasst, von der Transformatorprüfvorrichtung 10 automatisch ausgeführt werden.

Bei Schritt 71 wird die Transformatorprüfvorrichtung 10 lösbar mit dem Transformator 40 verbunden.

Bei Schritt 72 kann der Stufenschalter in eine Ausgangsposition gebracht werden, die beispielsweise einer maximalen Selbstinduktivität des Stufenschalters entsprechen kann.

Anschließend kann das Verhalten des Transformators 40 bei jedem Umschaltvorgang des Stufenschalters 43 automatisch erfasst werden. Optional kann für jede Schaltstufe des Stufenschalters 43 eine statische Widerstandsmessung vorgenommen werden, um den Wicklungswiderstand des Stufenschalters 43 zu ermitteln. Alternativ oder zusätzlich können andere Messungen zwischen den Umschaltvorgängen des Stufenschalters 43 erfolgen.

Bei Schritt 73 kann das steuerbare Schaltmittel 15 in einem Zustand sein, in dem die zweite Wicklung 42 nicht kurzgeschlossen ist. Dadurch kann eine raschere Stabilisierung des Transformators erreicht werden, wenn ein Gleichstrom an der Primärseite eingeprägt wird.

Bei Schritt 74 kann eine Widerstandsmessung erfolgen. Es kann ein Wicklungswiderstand des Stufenschalters 43 ermittelt werden.

Bei Schritt 75 kann das steuerbare Schaltmittel 15 so angesteuert werden, dass es geschlossen wird, um die zweite Wicklung 42 kurzzuschließen.

Bei Schritt 76 kann der Stufenschalter 43 betätigt werden, so dass ein Umschaltvorgang zwischen unterschiedlichen Schaltstufen ausgelöst wird. Während des Umschaltvorgangs kann eine Messung der Spannung am Stufenschalter 43 erfolgen. Die Quelle 13 kann dabei beispielsweise einen Gleichstrom einprägen. Aus der erfassten Spannung kann ein dynamischer Widerstand während des Umschaltvorgangs ermittelt werden.

Bei Schritt 77 kann überprüft werden, ob die letzte Stufe des Stufenschalters 43 erreicht wurde. Die letzte Stufe kann beispielsweise diejenige Stufe sein, bei der der Stufenschalter 43 die kleinste Selbstinduktivität aufweist. Falls die letzte Schaltstufe noch nicht erreicht ist, kann das Verfahren zu Schritt 73 zurückkehren. Das steuerbare Schaltmittel 15 kann geöffnet werden, um die zweite Wicklung 42 nicht kurzzuschließen.

Falls die letzte Schaltstufe erreicht ist, kann bei Schritt 78 die Transformatorprüfvorrichtung von dem Transformator abgetrennt werden. Es kann eine automatische weitere Auswertung und/oder Archivierung der Ergebnisse der Transformatorprüfung durch die Transformatorprüfvorrichtung erfolgen.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise die Verwendung einer Transformatorprüfvorrichtung in Kombination mit einem Transformator mit zwei Wicklungen beschrieben wurde, können die Vorrichtungen und Verfahren nach Ausführungsbeispielen auch für Transformatoren mit drei Wicklungen oder mehr als drei Wicklungen verwendet werden.

Während bei Ausführungsbeispielen die Transformatorprüfvorrichtung nur ein steuerbares Schaltmittel zum Kurzschließen nur einer Wicklung des Transformators umfassen kann, kann die Transformatorprüfvorrichtung auch zwei oder mehr als zwei steuerbare Schaltmittel zum Kurzschließen mehrerer Windungen des Transformators aufweisen. Die Transformatorprüfvorrichtung kann eingerichtet sein, um mehrere Wicklungen gleichzeitig oder zeitsequentiell kurzzuschließen.

Während bei Ausführungsbeispielen die Transformatorprüfvorrichtung zum Kurzschließen einer Unterspannungsseite eines Transformators eingerichtet sein kann, kann die Transformatorprüfvorrichtung auch eingerichtet sein, um alternativ oder zusätzlich zur Unterspannungsseite die Oberspannungsseite oder eine Tertiärwicklung des Transformators mit dem steuerbaren Schaltmittel kurzzuschließen.

Während bei Ausführungsbeispielen eine Prüfungsprozedur, die die Bestimmung mehrerer Kenngrößen des Transformators beinhaltet, automatisch ausgeführt werden kann, können die Transformatorprüfvorrichtung und das Verfahr nach Ausführungsbeispielen auch verwendet werden, wenn nur eine Kenngröße des Transformators gemessen wird, bevor eine neue Benutzereingabe erforderlich ist.

Während der Transformator in einem Kraftwerk oder Umspannwerk eines Energieversorgungsnetzes installiert sein kann, können die Transformatorprüfvorrichtung und das Verfahren nach Ausführungsbeispielen auch bei kleineren Transformatoren eingesetzt werden.

Transformatorprüfvorrichtung, Verfahren und Systeme nach Ausführungsbeispielen erlauben eine weitergehende Automatisierung bei der Transformatorprüfung.

## Patentansprüche

1. Transformatorprüfvorrichtung (10) zum Prüfen eines Transformators (40), umfassend
Anschlüsse (12) zur lösbaren Verbindung der Transformatorprüfvorrichtung (10) mit dem Transformator (40),
eine Quelle (13) zum Erzeugen eines Prüfsignals zum Prüfen des Transformators (40),
ein steuerbares Schaltmittel (15), das zum Kurzschließen wenigstens einer Wicklung (42) des Transformators (40) bei einer Transformatorprüfung mit den Anschlüssen (12) verbunden ist, und
eine Steuereinrichtung (17), die mit dem steuerbaren Schaltmittel (15) verbunden ist und eingerichtet ist, um das steuerbare Schaltmittel (15) gemäß einem Zeitablaufplan, der von einer ausgewählten Prüfungsprozedur abhängt, automatisch anzusteuern, wobei die ausgewählte Prüfungsprozedur einen ersten Teil (66) umfasst, in dem das steuerbare Schaltmittel (15) zur Messung einer ersten Kenngröße des Transformators (40) derart angesteuert wird, dass die wenigstens eine Wicklung (42) des Transformators (40) nicht kurzgeschlossen ist, und einen zweiten Teil (67), in dem das steuerbare Schaltmittel (15) zur Messung einer zweiten Kenngröße des Transformators (40) derart angesteuert wird, dass die wenigstens eine Wicklung (42) des Transformators (40) kurzgeschlossen ist..

2. Transformatorprüfvorrichtung (10) nach Anspruch 1, umfassend eine Benutzerschnittstelle (20) zum Auswählen der Prüfungsprozedur aus einer Mehrzahl von Prüfungsprozeduren.

3. Transformatorprüfvorrichtung (10) nach Anspruch 1 oder Anspruch 2,
wobei die Steuereinrichtung (17) eingerichtet ist, um das steuerbare Schaltmittel (15) und die Quelle (13) gemäß dem Zeitablaufplan anzusteuern.

4. Transformatorprüfvorrichtung (10) nach einem der vorhergehenden Ansprüche, umfassend
ein Gehäuse (11), in dem die Quelle (13), das steuerbare Schaltmittel (15) und die Steuereinrichtung (17) untergebracht sind,
wobei die Anschlüsse (12) an dem Gehäuse (11) vorgesehen sind, und
wobei das steuerbare Schaltmittel (15) zum Leiten eines Kurzschlussstroms bei der Transformatorprüfung eingerichtet ist.

5. Transformatorprüfvorrichtung (10) nach einem der Ansprüche 1 bis 4,
wobei die Transformatorprüfvorrichtung (10) eingerichtet ist, um die Messung an dem Transformator (40) bei einer Betätigung eines Stufenschalters (43) des Transformators (40) auszuführen.

6. Transformatorprüfvorrichtung (10) nach einem der Ansprüche 1 bis 5,
wobei die Quelle (13) selektiv als Stromquelle (13) oder als Spannungsquelle (13) betreibbar ist.

7. System, umfassend
einen Transformator (40) und
eine Transformatorprüfvorrichtung (10) nach einem der Ansprüche 1 bis 6, die über die Anschlüsse (12) lösbar mit dem Transformator (40) verbunden ist.

8. Verfahren zur Prüfung eines Transformators (40) mit einer Transformatorprüfvorrichtung (10),
wobei die Transformatorprüfvorrichtung (10) Anschlüsse (12) zur lösbaren Verbindung der Transformatorprüfvorrichtung (10) mit dem Transformator (40) und eine Steuereinrichtung (17) umfasst, die mit einem steuerbaren Schaltmittel (15) zum Kurzschließen wenigstens einer Wicklung (42) des Transformators (40) verbunden ist und eingerichtet ist, um das steuerbare Schaltmittel (15) zur Durchführung der Transformatorprüfung wenigstens einmal automatisch zu betätigen, und
wobei das steuerbare Schaltmittel (15) mit der Steuereinrichtung (17) gemäß einem Zeitablaufplan, der von einer ausgewählten Prüfungsprozedur abhängt, automatisch angesteuert wird, wobei die ausgewählte Prüfungsprozedur einen ersten Teil (66) umfasst, in dem das steuerbare Schaltmittel (15) zur Messung einer ersten Kenngröße des Transformators (40) derart angesteuert wird, dass die wenigstens eine Wicklung (42) des Transformators (40) nicht kurzgeschlossen ist, und einen zweiten Teil (67), in dem das steuerbare Schaltmittel (15) zur Messung einer zweiten Kenngröße des Transformators (40) derart angesteuert wird, dass die wenigstens eine Wicklung (42) des Transformators (40) kurzgeschlossen ist.

9. Verfahren nach Anspruch 8,
das mit der Transformatorprüfvorrichtung (10) nach einem der Ansprüche 1 bis 6 ausgeführt wird.

## Claims

1. A transformer test device (10) for testing a transformer (40), comprising connections (12) for releasably connecting the transformer test device (10) to the transformer (40),
a source (13) for generating a test signal for testing the transformer (40), and
a controllable switching means (15) which is connected to the connections (12) during a transformer test for the purpose of short-circuiting at least one winding (42) of the transformer (40), and
a control device (17) which is connected to the controllable switching means (15) and is configured to automatically actuate the controllable switching means (15) in accordance with a time schedule which depends on a selected test procedure, wherein the selected test procedure comprises a first part (66) in which the controllable switching means (15) is controlled for the measurement of a first characteristic variable of the transformer (40) such that the at least one winding (42) of the transformer (40) is not short-circuitet, and a second part (67) in which the controllable switching means (15) is controlled for the measurement of a second characteristic variable of the transformer (40) such that the at least one winding (42) of the transformer (40) is short-circuitet.

2. The transformer test device (10) according to claim 1, comprising a user interface (20) for selecting the test procedure from amongst a plurality of test procedures.

3. The transformer test device (10) according to claim 1 or claim 2,
wherein the control device (17) is configured to actuate the controllable switching means (15) and the source (13) in accordance with the time schedule.

4. The transformer test device (10) according to any one of the preceding claims, comprising
a housing (11) in which the source (13), the controllable switching means (15) and the control device (17) are accommodated,
wherein the connections (12) are provided at the housing (11), and
wherein the controllable switching means (15) is configured to conduct a short-circuit current during the transformer test.

5. The transformer test device (10) according to any one of claims 1 to 4,
wherein the transformer test device (10) is configured to perform the measurement at the transformer (40) in the event of an actuation of a tap changer (43) of the transformer (40).

6. The transformer test device (10) according to any one of claims 1 to 5,
wherein the source (13) can be selectively operated as a current source (13) or as a voltage source (13).

7. A system, comprising
a transformer (40) and
a transformer test device (10) according to any one of claims 1 to 6, which transformer test device is releasably connected to the transformer (40) by means of the connections (12).

8. A method for testing a transformer (40) by means of a transformer test device (10), wherein the transformer test device (10) comprises connections (12) for releasably connecting the transformer test device (10) to the transformer (40) and a control device (17) which is connected to a controllable switching means (15) for the purpose of short-circuiting at least one winding (42) of the transformer (40) and which is configured to automatically actuate the controllable switching means (15) at least once for carrying out the testing of the transformer, and
wherein the controllable switching means (15) is automatically controlled by the control device (17) in accordance with a time schedule which depends on a selected test procedure, wherein the selected test procedure comprises a first part (66) in which the controllable switching means (15) is controlled for the measurement of a first characteristic variable of the transformer (40) such that the at least one winding (42) of the transformer (40) is not short-circuitet, and a second part (67) in which the controllable switching means (15) is controlled for the measurement of a second characteristic variable of the transformer (40) such that the at least one winding (42) of the transformer (40) is short-circuitet.

9. The method according to claim 8,
which is performed with the transformer test device (10) according to any one of claims 1 to 6.

## Revendications

1. Dispositif de test de transformateur (10) destiné à tester un transformateur (40), comprenant
des bornes (12) permettant de relier de manière amovible le dispositif de test de transformateur (10) au transformateur (40),
une source (13) destinée à produire un signal de test pour tester le transformateur (40),
un moyen de commutation (15) réglable, qui est relié aux bornes (12) pour court-circuiter au moins un enroulement (42) du transformateur (40) lors d'un test de transformateur, et
un dispositif de réglage (17), qui est relié au moyen de commutation (15) réglable et est agencé pour actionner automatiquement le moyen de commutation (15) réglable selon un calendrier, qui dépend d'une procédure de test choisie, la procédure de test choisie comprenant une première partie (66), dans laquelle le moyen de commutation (15) réglable est actionné pour mesurer une première grandeur caractéristique du transformateur (40) de sorte que l'au moins un enroulement (42) du transformateur (40) n'est pas court-circuité, et une seconde partie (67), dans laquelle le moyen de commutation (15) réglable est actionné pour mesurer une seconde grandeur caractéristique du transformateur (40) de sorte que l'au moins un enroulement (42) du transformateur (40) est court-circuité.

2. Dispositif de test de transformateur (10) selon la revendication 1, comprenant une interface utilisateur (20) pour choisir la procédure de test parmi une pluralité de procédures de test.

3. Dispositif de test de transformateur (10) selon la revendication 1 ou la revendication 2, le dispositif de réglage (17) étant agencé pour actionner le moyen de commutation (15) réglable et la source (13) selon le calendrier.

4. Dispositif de test de transformateur (10) selon l'une quelconque des revendications précédentes, comprenant
un logement (11), dans lequel la source (13), le moyen de commutation (15) réglable et le dispositif de réglage (17) sont installés,
les bornes (12) étant prévues au niveau du logement (11), et
le moyen de commutation (15) réglable étant agencé pour guider un courant de court-circuit lors du test de transformateur.

5. Dispositif de test de transformateur (10) selon l'une quelconque des revendications 1 à 4, le dispositif de test de transformateur (10) étant agencé pour réaliser la mesure au niveau du transformateur (40) lors d'un actionnement d'un changeur de prise (43) du transformateur (40).

6. Dispositif de test de transformateur (10) selon l'une quelconque des revendications 1 à 5, la source (13) pouvant fonctionner sélectivement comme source de courant (13) ou comme source de tension (13).

7. Système, comprenant
un transformateur (40) et
un dispositif de test de transformateur (10) selon l'une quelconque des revendications 1 à 6, qui est relié de manière amovible par le biais des bornes (12) au transformateur (40).

8. Procédé destiné à tester un transformateur (40) avec un dispositif de test de transformateur (10),
le dispositif de test de transformateur (10) comprenant des bornes (12) pour relier de manière amovible le dispositif de test de transformateur (10) au transformateur (40) et un dispositif de réglage (17), qui est relié à un moyen de commutation (15) réglable pour court-circuiter au moins un enroulement (42) du transformateur (40) et est agencé pour actionner au moins une fois automatiquement le moyen de commutation (15) réglable pour la réalisation du test de transformateur, et
le moyen de commutation (15) réglable étant actionné automatiquement avec le dispositif de réglage (17) selon un calendrier, qui dépend d'une procédure de test choisie, la procédure de test choisie comprenant une première partie (66), dans laquelle le moyen de commutation (15) réglable est actionné pour mesurer une première grandeur caractéristique du transformateur (40) de sorte que l'au moins un enroulement (42) du transformateur (40) n'est pas court-circuité, et une seconde partie (67), dans laquelle le moyen de commutation (15) réglable est actionné pour mesurer une seconde grandeur caractéristique du transformateur (40) de sorte que l'au moins un enroulement (42) du transformateur (40) est court-circuité.

9. Procédé selon la revendication 8, qui est réalisé avec le dispositif de test de transformateur (10) selon l'une quelconque des revendications 1 à 6.
